# EUROPÄISCHE PATENTSCHRIFT

(11) **EP 3 262 907 B1**
(45) Veröffentlichungstag und Bekanntmachung des Hinweises auf die Patenterteilung: **10.04.2019**
(21) Anmeldenummer: 16705947.6
(22) Anmeldetag: 23.02.2016
(51) Int. Cl.: H05K 7/14

(54) **MODULARE FELDGERÄTEANSCHLUSSEINHEIT**
MODULAR FIELD DEVICE CONNECTION UNIT
UNITÉ MODULAIRE DE RACCORDEMENT D'APPAREIL DE TERRAIN

(30) Priorität: 25.02.2015 DE 102015002389
(43) Veröffentlichungstag der Anmeldung: 03.01.2018
(73) Patentinhaber: ABB Schweiz AG, 5400 Baden (CH)
(72) Erfinder: ERIKSSON, Rolf, 722 09 Västerås (SE); HAMMARSTRAND, Erik, 723 55 Västerås (SE); RASK, Owe, 722 41 Västerås (SE)
(74) Vertreter: Marks, Frank
(86) Internationale Anmeldenummer: PCT/EP2016/053738
(87) Internationale Veröffentlichungsnummer: WO 2016/135123

(56) Entgegenhaltungen:
- DE-C1- 10 135 980
- DE-C1- 19 616 516
- US-B1- 8 123 545

## Beschreibung

Die Erfindung betrifft eine modulare Feldgeräteanschlusseinheit zur elektrischen Verbindung von Feldgeräten mit einer Steuerungskomponente in einer automatisierungstechnischen Einrichtung.

Das Einsatzgebiet der Erfindung erstreckt sich auf prinzipiell alle Feldgeräte als technische Einrichtungen im Bereich der Automatisierungstechnik, die mit einem Produktionsprozess in direkter Beziehung stehen. Derartige Feldgeräte können sowohl Aktoren, wie Stellglieder oder Ventile, als auch Sensoren, wie Messumformer, in der Fabrik- und Prozessautomation sein. Die Feldgeräte sind mit Hilfe einer Anschlussleitung mit einem übergeordneten Steuerungssystem, meist über einen Feldbus, verbunden. Hierüber werden die Daten ausgetauscht und dienen dann zur Regelung, Steuerung und weiteren Verarbeitung. Häufig verwendete Kommunikationsstandards für Feldbus sind CAN, HART, PROFIBUS oder können auch auf Basis von ETHERNET, Profinet, IP ausgebildet sein.

Darüber hinaus sind diese Feldgeräte, insbesondere 4-20 mA Geräte aber auch solche mit Feldbus, über diese Anschlussleitung energieversorgt.

In der Praxis werden die Anschlussleitung nicht direkt von dem jeweiligen Feldgerät zu der Steuerungskomponente geführt sondern zunächst individuell vom jeweiligen Feldgerät zu einer Feldgeräteanschlusseinheit, welche dann mit einer Sammelleitung, insbesondere einer Busleitung, mit der Steuerungskomponente verbunden ist. Aus der DE 101 35 980 C1 ist eine Anordnung zum Anschluss von dezentral und prozeßnah angeordneten Feldgeräten an eine entfernte zentrale Einrichtung in einer automatisierungstechnischen Anlage mit einem Verteiler bekannt der mindestens eine Kommunikationsschnittstelle zur Kommunikation mit der entfernten zentralen Einrichtung, eine Mehrzahl von steckbaren Ein-/Ausgabe-Baugruppen und ein vielpoliges Anschlußklemmenfeld zum Anschluß von Feldgeräten aufweist. Die Ein-/Ausgabe- Baugruppen weisen eine systemseitige Kommunikationsschnittstelle und eine feldseitige Kommunikationsschnittstelle in derselben Steckebene auf. Die systemseitigen Kommunikationsschnittstellen der E/A-Baugruppen sind mit der Kommunikationsschnittstelle zur Kommunikation mit der zentralen Einrichtung verbunden. Die feldseitigen Kommunikationsschnittstellen der E/A-Baugruppen und das Anschlußklemmenfeld sind an voneinander getrennte Kontakte einer Steckkontaktvorrichtung angeschlossen.

Dabei ist eine konfigurationsbestimmende Steckeinheit vorgesehen, die eine zu der Steckkontaktvorrichtung korrespondierende Steckgegenkontaktvorrichtung und Leiterbrücken zur elektrischen Verbindung voneinander getrennter Kontakte der Steckkontaktvorrichtung derart aufweist, daß jeweils ein Feldgerät mit der feldseitigen Kommunikationsschnittstelle mindestens einer E/A-Baugruppe verbunden ist. Fehlerhafte Bestückungen der Einrichtung mit falschen konfigurationsbestimmenden Steckeinheiten können dabei schwerwiegende Fehler in der Feldgeräteanschlusseinheit hervorrufen.

Es besteht daher ein Bedarf, die Feldgeräteanschlusseinheit testen zu können. Nachteiligerweise sind bei der bekannten Feldgeräteanschlusseinheit die Feldgeräte über die Feldverkabelung an die Feldgeräteanschlusseinheit angeschlossen. Das Ab- und Wiederanklemmen der Feldverkabelung ist sehr aufwändig und das Wiederanklemmen darüber hinaus fehlerträchtig.

Darüber hinaus ist aus der DE 196 16 516 C1 ein Trennadapter zum Einsatz in Steuerungssystemen mit einer Anschlußbaugruppe und einem Elektronikmodul bekannt, der zur Anschlußbaugruppe sowie zum Elektronikmodul jeweils passende mechanische und elektrische, miteinander funktionserhaltend verbundene Anschlußeinrichtungen und Einrichtungen zur Trennung der elektrischen Verbindung zwischen Signalleiterelementen und Elektronikmodul aufweist. Der im unbetätigten Zustand der Trenneinrichtungen elektrisch passive Trennadapter kann durch Betätigen der Trenneinrichtung für einzelne Signalleiterelemente oder auch Gruppen von Signalleiterelementen eine Verbindung zwischen Initiator, Aktor, Feldgerät oder dergleichen und Elektronikmodul gezielt unterbrechen, ohne daß die Gesamtfunktion des Steuerungssystems und insbesondere die Aufrechterhaltung einzelner Funktionen des Steuerungssystems gemindert wird.

Der Erfindung liegt daher die Aufgabe zugrunde, eine Feldgeräteanschlusseinheit anzugeben, die vollumfänglich testbar ist und während der Testphase von der Feldverkabelung galvanisch getrennt ist.

Erfindungsgemäß wird diese Aufgabe mit den Mitteln des Patentanspruchs 1 gelöst. Vorteilhafte Ausgestaltungen der Erfindung sind in den rückbezogenen Ansprüchen angegeben.

Die Erfindung geht aus von einer Feldgeräteanschlusseinheit mit einem Grundkörper, auf der eine Mehrzahl von Anschlusselementen zum Anschluss von Verbindungsleitungen mit Feldgeräten und eine Mehrzahl von Steckplätzen zur Aufnahme von jeweils einer Steckeinheit angeordnet sind. Die Steckeinheit weist eine erste Gruppe feldseitiger Steckkontaktvorrichtungen, welche mit den Anschlusselementen zum Anschluss von Verbindungsleitungen mit Feldgeräten verbunden sind, und eine zweite Gruppe systemseitiger Steckkontaktvorrichtungen auf, welche mit einer übergeordneten Einrichtung verbunden sind.

Erfindungsgemäß weist die Feldgeräteanschlusseinheit folgende Merkmale auf:
1. Die Steckeinheit umfasst eine mechanische Schaltvorrichtung mit mindestens einer ersten und einer zweiten Schaltstellung, welche einen federnd ausgebildeten Rastnocken aufweist, wobei der Rastnocken in der ersten Schaltstellung in die Steckeinheit eingezogen ist und in der zweiten Schaltstellung aus der Steckeinheit herausragt.
2. Der Grundkörper ist für jede Steckeinheit mit einer Führung ausgerüstet, welche mindestens eine erste Ausnehmung aufweist, welche zur Aufnahme des Rastnockens ausgebildet ist.
3. Die Kontakte der zweiten Gruppe systemseitiger Steckkontaktvorrichtungen sind voreilend gegenüber den Kontakten der ersten Gruppe feldseitiger Steckkontaktvorrichtungen.
4. Im eingerasteten Zustand des Rastnockens in der Ausnehmung sind die Kontakte der zweiten Gruppe systemseitiger Steckkontaktvorrichtungen geschlossen und die Kontakte der ersten Gruppe feldseitiger Steckkontaktvorrichtungen geöffnet.

Eine Steckeinheit mit einer mechanischen Schaltvorrichtung in der ersten Schaltstellung ist uneingeschränkt steckbar und ziehbar. Im gesteckten Zustand der Steckeinheit sind alle Kontakte der ersten Gruppe feldseitiger Steckkontaktvorrichtungen und der zweiten Gruppe systemseitiger Steckkontaktvorrichtungen geschlossen. Im gezogenen Zustand der Steckeinheit sind alle Kontakte der ersten Gruppe feldseitiger Steckkontaktvorrichtungen und der zweiten Gruppe systemseitiger Steckkontaktvorrichtungen geöffnet. Der Rastnocken ist in das Innere der Steckeinheit eingezogen.

Eine Steckeinheit mit einer mechanischen Schaltvorrichtung in der zweiten Schaltstellung ist unabhängig von ihrer Bewegungsrichtung entlang der Führung soweit steckbar oder ziehbar, bis der Rastnocken in die erste Ausnehmung einrastet. Dabei gleitet der Rastnocken federnd in der Führung bis zum Erreichen der erste Ausnehmung.

Beim Stecken der Steckeinheit sind zunächst alle Kontakte der ersten Gruppe feldseitiger Steckkontaktvorrichtungen und der zweiten Gruppe systemseitiger Steckkontaktvorrichtungen geöffnet. Sobald der Rastnocken in die Ausnehmung einrastet, ist der Steckvorgang beendet. Im eingerasteten Zustand des Rastnockens in der ersten Ausnehmung sind die Kontakte der zweiten Gruppe systemseitiger Steckkontaktvorrichtungen geschlossen und die Kontakte der ersten Gruppe feldseitiger Steckkontaktvorrichtungen geöffnet.

Beim Ziehen der Steckeinheit sind zunächst alle Kontakte der ersten Gruppe feldseitiger Steckkontaktvorrichtungen und der zweiten Gruppe systemseitiger Steckkontaktvorrichtungen geschlossen. Im eingerasteten Zustand des Rastnockens in der ersten Ausnehmung sind die Kontakte der zweiten Gruppe systemseitiger Steckkontaktvorrichtungen geschlossen und die Kontakte der ersten Gruppe feldseitiger Steckkontaktvorrichtungen geöffnet.

Im eingerasteten Zustand des Rastnockens in der ersten Ausnehmung ist die Feldgeräteanschlusseinheit bei abgetrennter Feldverkabelung für sich vollumfänglich testbar. Bei der Inbetriebnahme können Systemfunktionen der Feldgeräteanschlusseinheit unabhängig vom Zustand der Feldverkabelung geprüft werden. Dadurch wird die zeitgleiche und unabhängige Bearbeitung, insbesondere Anschließen und Prüfen, der Feldgeräteanschlüsse und Feldverkabelung auf der einen Seite und der Feldgeräteanschlusseinheit nebst übergeordneter Einrichtung auf der anderen Seite.

Darüber hinaus wird die empfindliche Elektronik der Feldgeräteanschlusseinheit vor den schädigenden Wirkungen von Kurzschlüssen, Erdungen und anderen Fehlschaltungen innerhalb der Feldverkabelung während deren Installation geschützt.

Vorteilhafterweise werden auch die an der Feldverkabelung angeschlossenen Feldgeräte vor unzulässigen Spannungen aus der Feldgeräteanschlusseinheit geschützt.

Ein weiterer Vorteil der erfindungsgemäßen Feldgeräteanschlusseinheit ist darin zu sehen, dass beim Austausch eines aus der Feldgeräteanschlusseinheit gespeisten Feldgeräts vermieden wird, die gesamte Feldgeräteanschlusseinheit abschalten zu müssen. Vielmehr ist lediglich die zu dem auszutauschenden Feldgerät gehörende Steckeinheit in den eingerasteten Zustand des Rastnockens in der ersten Ausnehmung zu versetzen. In diesem Zustand ist die Feldverkabelung dieses Feldgeräts von der Feldgeräteanschlusseinheit getrennt; das Feldgerät ist spannungsfrei und gefahrlos austauschbar.

Nach einem weiteren Merkmal der Erfindung ist die mechanische Schaltvorrichtung als Schieber ausgebildet, dessen Bewegungsrichtung quer zur Steckrichtung der Steckeinheit in der Ebene zwischen den Führungen des Grundkörpers ausgerichtet ist, wobei der Rastnocken in der Bewegungsrichtung des Schiebers federnd ausgebildet ist.

Vorteilhafterweise wird dadurch eine einfache und sichere Führung des Rastnockens in der Bewegungsrichtung des Schiebers erreicht.

Nach einem weiteren Merkmal der Erfindung weist die mechanische Schaltvorrichtung eine dritte Schaltstellung und einen starren Arretiernocken auf, welcher bei vollständig eingesteckter Steckeinheit quer zur Bewegungsrichtung der Steckeinheit in eine Ausnehmung des Grundkörpers führbar ist.

Nach einem weiteren Merkmal der Erfindung weist die Führung des Grundkörpers eine zweite Ausnehmung auf. Diese zweite Ausnehmung ist korrespondierend zu dem starren Arretiernocken bei vollständig eingesteckter Steckeinheit angeordnet.

Nach einem weiteren Merkmal der Erfindung weist die mechanische Schaltvorrichtung eine mittige Ruhestellung auf, in der der Rastnocken und der Arretiernocken in das Innere der Steckeinheit eingezogen sind. An gegenüberliegenden Seiten der Ruhestellung sind in Bewegungsrichtung der mechanische Schaltvorrichtung die zweite und die dritte Schaltstellung angeordnet.

Die Erfindung wird nachstehend anhand eines Ausführungsbeispiels näher erläutert. Die dazu erforderlichen Zeichnungen zeigen:
- Figur 1: eine perspektivische Darstellung einer Feldgeräteanschlusseinheit
- Figur 2: eine Explosivdarstellung einer Steckeinheit
- Figur 3: eine Prinzipdarstellung einer Leiterplatte mit voreilenden Kontakten
- Figur 4: eine perspektivische und eine geschnittene Darstellung einer Steckeinheit mit einer mechanischen Schaltvorrichtung in Ruhestellung
- Figur 5: eine perspektivische und eine geschnittene Darstellung einer Steckeinheit im vollständig eingesteckten Zustand
- Figur 6: eine perspektivische und eine geschnittene Darstellung einer Steckeinheit im teilweise gezogenen, eingerasteten Zustand
- Figur 7: eine perspektivische und eine geschnittene Darstellung einer Steckeinheit im gezogenen Zustand gezeigt

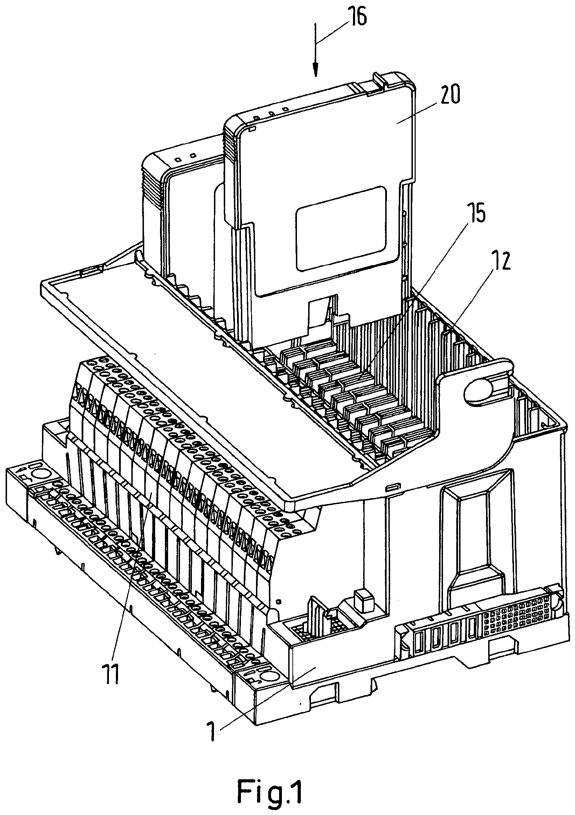

In der Figur 1 ist eine Feldgeräteanschlusseinheit mit einem Grundkörper **10**, auf dem eine Mehrzahl von Anschlusselementen **11** zum Anschluss von Verbindungsleitungen mit Feldgeräten und eine Mehrzahl von Steckplätzen zur Aufnahme von jeweils einer Steckeinheit **20** perspektivisch dargestellt. Jede Steckeinheit **20** ist einem Anschlusselement **11** zugeordnet. Die Anschlusselemente **11** weisen Schraubklemmen zum Anschluss von Verbindungsleitungen mit Feldgeräten auf.

Der Grundkörper **10** weist an jedem Steckplatz Führungen **12** auf, in denen die jeweilige Steckeinheit **20** beim Stecken in Steckrichtung **16** und Ziehen entgegen der Steckrichtung **16** geführt wird. An jedem Steckplatz sind Steckgegenkontaktvorrichtungen **15** zum feldseitigen und systemseitigen Anschluss vorgesehen, die in derselben Ebene angeordnet sind

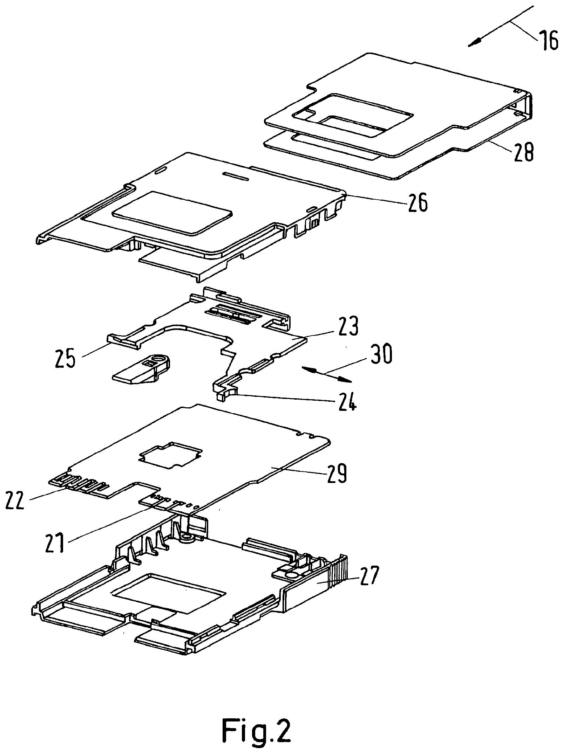

In der Figur 2 ist unter Verwendung gleicher Bezugszeichen für gleiche Mittel eine Steckeinheit **20** gezeigt. Die Steckeinheit **20** besteht im Wesentlichen aus zwei miteinander korrespondierenden Gehäuseschalen **26** und **27**, welche durch eine Klammer **28** zusammengehalten werden.

Im Inneren der Steckeinheit **20** ist eine Leiterplatte **29** zur Aufnahme der funktionalen Elektronik der Steckeinheit **20** angeordnet. Die Leiterplatte **29** weist eine erste Gruppe feldseitiger Steckkontaktvorrichtungen **21**, welche im gesteckten Zustand mit den Anschlusselementen **11** zum Anschluss von Verbindungsleitungen mit Feldgeräten verbunden sind, und eine zweite Gruppe systemseitiger Steckkontaktvorrichtungen **22** auf, welche im gesteckten Zustand mit einer übergeordneten Einrichtung verbunden sind.

Darüber hinaus ist im Inneren der Steckeinheit **20** eine mechanische Schaltvorrichtung **23** untergebracht, welche als Schieber ausgebildet ist, dessen Bewegungsrichtung **30** quer zur Steckrichtung **16** der Steckeinheit **20** in der Ebene zwischen den Führungen **12** des Grundkörpers **10** ausgerichtet ist. Die mechanische Schaltvorrichtung **23** ist mit einem einen federnd ausgebildeten Rastnocken **24** und einem starren Arretiernocken **25** ausgestattet. Die mechanische Schaltvorrichtung **23** ist von außen betätigbar und weist drei Schaltstellungen auf. Die Mittellage der mechanische Schaltvorrichtung **23** ist die Ruhestellung. An gegenüberliegenden Seiten der Ruhestellung sind in Bewegungsrichtung **30** der mechanische Schaltvorrichtung **23** die zweite und die dritte Schaltstellung angeordnet, welche nachfolgend näher beschrieben werden.

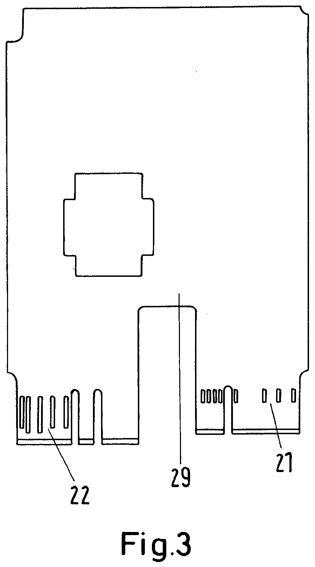

In der Figur 3 ist unter Verwendung gleicher Bezugszeichen für gleiche Mittel die Leiterplatte **29** im Umfang der erfindungswesentlichen Mittel prinzipiell dargestellt. Die Leiterplatte **29** weist Gruppen von Kontaktflächen auf, welche die feldseitigen Steckkontaktvorrichtungen **21** und die systemseitigen Steckkontaktvorrichtungen **22** bilden. Die Kontaktflächen der der zweiten Gruppe systemseitiger Steckkontaktvorrichtungen **22** sind länger als die Kontaktflächen der ersten Gruppe feldseitiger Steckkontaktvorrichtungen **21** und sind näher an die grundkörperseitige Kante der Leiterplatte **29** geführt. Die Kontakte der zweiten Gruppe systemseitiger Steckkontaktvorrichtungen **22** sind bei feldseitigen und systemseitigen Steckgegenkontaktvorrichtungen **15** in derselben Ebene voreilend gegenüber den Kontakten der ersten Gruppe feldseitiger Steckkontaktvorrichtungen **21**.

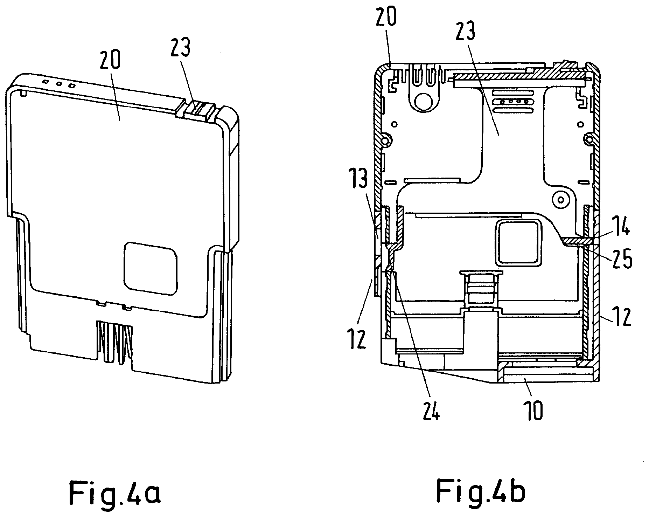

In der Figur 4 sind unter Verwendung gleicher Bezugszeichen für gleiche Mittel eine perspektivische und eine geschnittene Darstellung der Steckeinheit **20** mit einer mechanischen Schaltvorrichtung **23** in Ruhestellung gezeigt. Die mechanische Schaltvorrichtung **23** befindet sich in der Mittelstellung. Der Rastnocken **24** und der Arretiernocken **25** sind in das Innere der Steckeinheit **20** eingezogen. Die Steckeinheit **20** kann in dieser Ruhestellung der mechanischen Schaltvorrichtung **23** vollständig aus dem Grundkörper **10** herausgezogen oder vollständig aus dem Grundkörper **10** herausgezogen werden.

In der geschnittenen Darstellung der Figur 4b ist die Steckeinheit **20** im vollständig in den Grundkörper **10** eingesteckten Zustand dargestellt. Die Führungen **12** des Grundkörpers **10** weisen eine erste Ausnehmung **13** und eine zweite Ausnehmung **14** auf. Die Ausnehmungen **13** und **14** sind in gegenüberliegenden Führungen **12** angeordnet. Die zweite Ausnehmung **14** ist passend zum Arretiernocken **25** angeordnet. Zur Arretierung der Steckeinheit **20** im vollständig eingesteckten Zustand wird die mechanische Schaltvorrichtung **23** und somit der Arretiernocken 25 in Richtung der zweiten Ausnehmung **14** in die dritte Schaltstellung verbracht. Damit ist die Steckeinheit **20** im Grundkörper **10** arretiert. Darüber hinaus sind feldseitigen Steckkontaktvorrichtungen **21** und die systemseitigen Steckkontaktvorrichtungen **22** mit den korrepondierenden Steckgegenkontaktvorrichtungen **15** vollständig in elektrischem Kontakt.

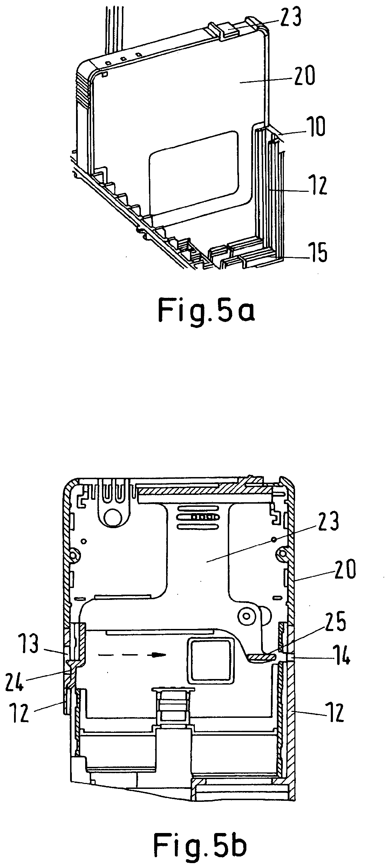

In der Figur 5 sind unter Verwendung gleicher Bezugszeichen für gleiche Mittel eine perspektivische und eine geschnittene Darstellung der Steckeinheit **20** im vollständig eingesteckten Zustand gezeigt, wobei die mechanische Schaltvorrichtung **23** in der zweiten Schaltstellung dargestellt ist. In dieser zweiten Schaltstellung ist der Arretiernocken **25** weit in das Innere der Steckeinheit **20** eingezogen. Der Rastnocken **24** ist federnd im Inneren der Steckeinheit **20** vorgespannt.

Beim Ziehen der Steckeinheit **20** gleitet der Rastnocken **24** in der Führung **12** des Grundkörpers **10** bis zum Erreichen der ersten Ausnehmung **13** und rastet in die erste Ausnehmung **13** ein.

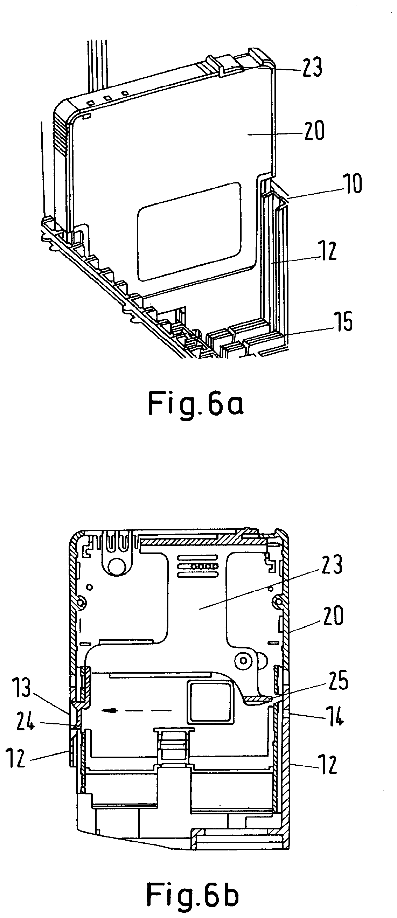

In der Figur 6 sind unter Verwendung gleicher Bezugszeichen für gleiche Mittel eine perspektivische und eine geschnittene Darstellung der Steckeinheit **20** im teilweise gezogenen, eingerasteten Zustand gezeigt. Dieser Zustand wird sowohl beim Stecken als auch beim Ziehen der Steckeinheit **20** erreicht, soweit sich die mechanische Schaltvorrichtung **23** in der zweiten Schaltstellung befindet.

Der federnde Rastnocken **24** ist in die erste Ausnehmung **13** eingerastet. Die feldseitigen Steckkontaktvorrichtungen **21** sind von den korrepondierenden Steckgegenkontaktvorrichtungen **15** getrennt, während die systemseitigen Steckkontaktvorrichtungen **22** mit den korrepondierenden Steckgegenkontaktvorrichtungen **15** elektrisch verbunden sind.

Zum Verlassen des eingerasteten Zustands wird die mechanische Schaltvorrichtung **23** in die neutrale Ruhestellung gemäß obiger Beschreibung zu Figur 4 verbracht.

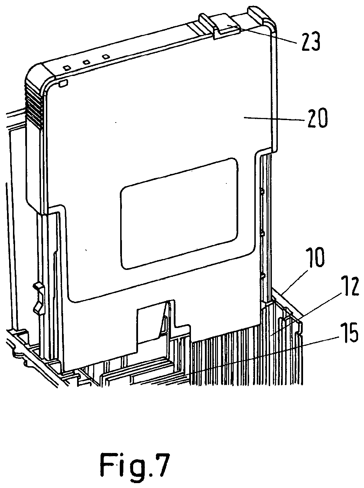

In der Figur 7 ist unter Verwendung gleicher Bezugszeichen für gleiche Mittel eine perspektivische Darstellung der Steckeinheit **20** im gezogenen Zustand gezeigt, wobei die mechanische Schaltvorrichtung **23** in der zweiten Schaltstellung dargestellt ist. Der Rastnocken **24** ragt über die Außenkontur der Steckeinheit **20** hinaus. Alle elektrischen Steckkontaktvorrichtungen der Steckeinheit **20** sind von den korrepondierenden Steckgegenkontaktvorrichtungen **15** getrennt.

Beim Stecken der Steckeinheit **20** gleitet der Rastnocken **24** in der Führung **12** des Grundkörpers **10** bis zum Erreichen der ersten Ausnehmung **13** und rastet in die erste Ausnehmung **13** ein. Damit ist der eingerastete Zustand der Steckeinheit **20** gemäß der obigen Beschreibung zu Figur 6 erreicht.

### Bezugszeichenliste

- 10: Grundkörper
- 11: Anschlusselement
- 12: Führung
- 13, 14: Ausnehmung
- 15: Steckgegenkontaktvorrichtung
- 16: Steckrichtung

- 20: Steckeinheit
- 21: feldseitige Steckkontaktvorrichtung
- 22: systemseitige Steckkontaktvorrichtung
- 23: mechanische Schaltvorrichtung
- 24: Rastnocken
- 25: Arretiernocken
- 26, 27: Gehäuseschale
- 28: Klammer
- 29: Leiterplatte
- 30: Bewegungsrichtung

## Patentansprüche

1. Feldgeräteanschlusseinheit mit einer Grundkörper (10), auf dem eine Mehrzahl von Anschlusselementen (11) zum Anschluss von Verbindungsleitungen mit Feldgeräten und eine Mehrzahl von Steckplätzen zur Aufnahme von jeweils einer Steckeinheit (20) angeordnet sind, wobei die Steckeinheit (20) eine erste Gruppe feldseitiger Steckkontaktvorrichtungen (21), welche mit den Anschlusselementen zum Anschluss von Verbindungsleitungen mit Feldgeräten verbunden sind, und eine zweite Gruppe systemseitiger Steckkontaktvorrichtungen (22) aufweist, welche mit einer übergeordneten Einrichtung verbunden sind
**dadurch gekennzeichnet,**
- **dass** die Steckeinheit (20) eine mechanische Schaltvorrichtung (23) mit mindestens einer ersten und einer zweiten Schaltstellung umfasst, welche einen federnd ausgebildeten Rastnocken (24) aufweist, wobei der Rastnocken (24) in der ersten Schaltstellung in die Steckeinheit (20) eingezogen ist und in der zweiten Schaltstellung aus der Steckeinheit (20) herausragt,
- **dass** der Grundkörper (10) für jede Steckeinheit (20) mit einer Führung (12) ausgerüstet ist, welche mindestens eine erste Ausnehmung (13) aufweist, welche zur Aufnahme des Rastnockens (24) ausgebildet ist,
- **dass** die Kontakte der zweiten Gruppe systemseitiger Steckkontaktvorrichtungen (22) voreilend gegenüber den Kontakten der ersten Gruppe feldseitiger Steckkontaktvorrichtungen (21) sind und
- **dass** im eingerasteten Zustand des Rastnockens (24) in der ersten Ausnehmung (13) die Kontakte der zweiten Gruppe systemseitiger Steckkontaktvorrichtungen (22) geschlossen und die Kontakte der ersten Gruppe feldseitiger Steckkontaktvorrichtungen (21) geöffnet sind.

2. Feldgeräteanschlusseinheit nach Anspruch 1
**dadurch gekennzeichnet,**
**dass** die mechanische Schaltvorrichtung (23) als Schieber ausgebildet ist, dessen Bewegungsrichtung quer zur Steckrichtung der Steckeinheit (20) in der Ebene zwischen Führungen (12) des Grundkörpers (10) ausgerichtet ist, wobei der Rastnocken (24) in der Bewegungsrichtung des Schiebers federnd ausgebildet ist.

3. Feldgeräteanschlusseinheit nach einem der Ansprüche 1 und 2
**dadurch gekennzeichnet,**
**dass** die mechanische Schaltvorrichtung (23) eine dritte Schaltstellung und einen starren Arretiernocken (25) aufweist, welcher bei vollständig eingesteckter Steckeinheit (20) quer zur Bewegungsrichtung der Steckeinheit (20) in eine Ausnehmung des Grundkörpers (10) führbar ist.

4. Feldgeräteanschlusseinheit nach einem der vorstehenden Ansprüche
**dadurch gekennzeichnet,**
**dass** die Führung (12) des Grundkörpers (10) eine zweite Ausnehmung (14) aufweist, welche korrespondierend zu dem starren Arretiernocken (25) bei vollständig eingesteckter Steckeinheit (20) angeordnet ist.

5. Feldgeräteanschlusseinheit nach einem der vorstehenden Ansprüche
**dadurch gekennzeichnet,**
**dass** die mechanische Schaltvorrichtung (23) eine mittige Ruhestellung aufweist, in der der Rastnocken (24) und der Arretiernocken (25) in das Innere der Steckeinheit (20) eingezogen sind.

## Claims

1. Field device connection unit having a main body (10) on which a plurality of connection elements (11) for the connection of connecting lines to field devices and a plurality of slots for receiving a respective plug-in unit (20) are arranged, wherein the plug-in unit (20) comprises a first group of field-side plug-in contact apparatuses (21), which are connected to the connection elements for the connection of connecting lines to field devices, and a second group of system-side plug-in contact apparatuses (22), which are connected to a superordinate device,
**characterized**
- **in that** the plug-in unit (20) has a mechanical switching apparatus (23) with at least one first and one second switching position, which mechanical switching apparatus has a resilient latching cam (24), wherein the latching cam (24) is retracted into the plug-in unit (20) in the first switching position and protrudes out of the plug-in unit (20) in the second switching position,
- **in that** the main body (10) is equipped with a guide (12) for each plug-in unit (20), which guide has at least one first recess (13) which is designed for receiving the latching cam (24),
- **in that** the contacts of the second group of system-side plug-in contact apparatuses (22) are ahead of the contacts of the first group of field-side plug-in contact apparatuses (21), and
- **in that**, when the latching cam (24) is in the latched-in state in the first recess (13), the contacts of the second group of system-side plug-in contact apparatuses (22) are closed and the contacts of the first group of field-side plug-in contact apparatuses (21) are opened.

2. Field device connection unit according to Claim 1, **characterized**
**in that** the mechanical switching apparatus (23) is designed as a slide, the movement direction of which slide is oriented transversely in relation to the insertion direction of the plug-in unit (20) in the plane between guides (12) of the main body (10), wherein the latching cam (24) is designed to be resilient in the movement direction of the slide.

3. Field device connection unit according to either of Claims 1 and 2,
**characterized**
**in that** the mechanical switching apparatus (23) has a third switching position and a rigid locking cam (25) which, when the plug-in unit (20) is fully inserted, can be guided transversely in relation to the movement direction of the plug-in unit (20) into a recess of the main body (10).

4. Field device connection unit according to one of the preceding claims,
**characterized**
**in that** the guide (12) of the main body (10) has a second recess (14) which is arranged so as to correspond to the rigid locking cam (25) when the plug-in unit (20) is fully inserted.

5. Field device connection unit according to one of the preceding claims,
**characterized**
**in that** the mechanical switching apparatus (23) has a central inoperative position in which the latching cam (24) and the locking cam (25) are retracted into the interior of the plug-in unit (20).

## Revendications

1. Unité de connexions de terrain dotée d'un corps principal (10), auquel une pluralité d'éléments de connexion (11) destinés à connecter des câbles de raccordement à des appareils de terrain et une pluralité de connecteurs destinés à accueillir respectivement une unité enfichable (20) sont agencées, dans laquelle l'unité enfichable (20) comporte un premier groupe de dispositifs de fiches de contact côté terrain (21), lesquelles sont raccordées aux éléments de connexion pour connecter les câbles de raccordement aux appareils de terrain, et un deuxième groupe de dispositifs de fiches de contact côté système (22), lesquelles sont raccordées à un dispositif d'ordre supérieur, **caractérisée**
- **en ce que** l'unité enfichable (20) comprend un contacteur mécanique (23) doté d'au moins un premier et un deuxième état de commutation, lequel comporte une came d'encliquetage (24) conçue de manière élastique, dans laquelle la came d'encliquetage (24) est rétractée dans l'unité enfichable (20) dans le premier état de commutation et dépasse de l'unité enfichable (20) dans le deuxième état de commutation,
- **en ce que** le corps principal (10) est équipé d'un guidage (12) pour chaque unité enfichable (20), lequel comporte au moins une première cavité (13), laquelle est conçue pour accueillir la came d'encliquetage (24),
- **en ce que** les contacts du deuxième groupe de dispositifs de fiches de contact côté système (22) sont en avant par rapport aux contacts du premier groupe de dispositifs de fiches de contact côté terrain (21) et
- **en ce que** dans la position où la came d'encliquetage (24) est engagée dans la première cavité (13) les contacts du deuxième groupe de dispositifs de fiches de contact côté système (22) sont fermés et les contacts du premier groupe de dispositifs de fiches de contact côté terrain (21) sont ouverts.

2. Unité de connexions de terrain selon la revendication 1, **caractérisée en ce que** le contacteur mécanique (23) est conçu comme un curseur, dont la direction de mouvement est orientée transversalement à la direction d'enfichage de l'unité enfichable (20) dans le plan entre des guidages (12) du corps principal (10), dans laquelle la came d'encliquetage (24) est conçue pour être élastique dans la direction de mouvement du curseur.

3. Unité de connexions de terrain selon l'une des revendications 1 et 2, **caractérisée en ce que** le contacteur mécanique (23) comporte un troisième état de commutation et une came d'arrêt rigide (25), laquelle peut être guidée dans une cavité du corps principal (10) transversalement à la direction de mouvement de l'unité enfichable (20) lorsque l'unité enfichable (20) est complètement enfichée.

4. Unité de connexions de terrain selon l'une des revendications précédentes, **caractérisée en ce que** le guidage (12) du corps principal (10) comporte une deuxième cavité (14), laquelle est agencée pour correspondre à la came d'arrêt rigide (25) lorsque l'unité enfichable (20) est complètement enfichée.

5. Unité de connexions de terrain selon l'une des revendications précédentes, **caractérisée en ce que** le contacteur mécanique (23) comporte une position de repos centrale, où la came d'encliquetage (24) et la came d'arrêt (25) sont rétractées à l'intérieur de l'unité enfichable (20).
